# EUROPÄISCHE PATENTSCHRIFT

(11) **EP 0 674 228 B1**
(45) Veröffentlichungstag und Bekanntmachung des Hinweises auf die Patenterteilung: **04.09.2002**
(21) Anmeldenummer: 95102216.9
(22) Anmeldetag: 17.02.1995
(51) Int. Cl.: G03F 7/20

(54) **Lithografisches Verfahren**
Lithographic method
Méthode lithographique

(30) Priorität: 14.03.1994 DE 4408507
(43) Veröffentlichungstag der Anmeldung: 27.09.1995
(73) Patentinhaber: Heidelberg Instruments Mikrotechnik GmbH, D-69126 Heidelberg (DE)
(72) Erfinder: Wijnaendts, Roelof, Dr., D-76669 Bad Schönborn (DE); Buchner, Christian, D-69120 Heidelberg (DE)
(74) Vertreter: Klose, Hans, Dipl.-Phys.

(56) Entgegenhaltungen:
- APPLIED OPTICS, 1 NOV. 1987, USA, Bd. 26, Nr. 21, ISSN 0003-6935, Seiten 4587-4592, HARUNA M ET AL 'Laser-beam writing system for optical integrated circuits'
- PATENT ABSTRACTS OF JAPAN vol. 012 no. 051 (P-667) ,16.Februar 1988 & JP-A-62 198861 (HOYA CORP) 2.September 1987,
- IBM TECHNICAL DISCLOSURE BULLETIN, Bd. 32, Nr. 5B, Oktober 1989 NEW YORK, US, Seiten 116-117, ANONYMOUS 'Resolution Enhancement in Dry Film Photoresist'
- INTERNATIONAL CONFERENCE ON MICROLITHOGRAPHY: MICROCIRCUIT ENGINEERING 87, PARIS, FRANCE, 22-25 SEPT. 1987, Bd. 6, Nr. 1-4, ISSN 0167-9317, MICROELECTRONIC ENGINEERING, DEC. 1987, NETHERLANDS, Seiten 77-84, ULRICH H ET AL 'Direct writing laser lithography for production of microstructures'
- OPTICAL ENGINEERING, JAN. 1986, USA, Bd. 25, Nr. 1, ISSN 0091-3286, Seiten 180-183, KUTTNER P 'Image quality of optical systems for truncated Gaussian laser beams'
- IBM TECHNICAL DISCLOSURE BULLETIN, Bd. 23, Nr. 7A, Dezember 1980 NEW YORK, US, Seiten 2723-2724, ANONYMOUS 'Frequency Dependent Mask Windage for Improved Mask Modulation. December 1980.'
- NANOFABRICATION TECHNOLOGIES AND DEVICE INTEGRATION, LINDAU, GERMANY, 13-14 APRIL 1994, Bd. 2213, ISSN 0277-786X, PROCEEDINGS OF THE SPIE - THE INTERNATIONAL SOCIETY FOR OPTICAL ENGINEERING, 1994, USA, Seiten 18-23, WIJNAENDTS-VAN-RESANDT R W ET AL 'Super resolution lithography using a direct write laser pattern generator'
- MICHAEL C. KING AND DAVID A. MARKLE: 'Short Course Notes' OPTICAL LITHOGRAPHY SPIE'S 1990 SYMPOSIUM ON MICROLITHOGRAPHY, SAN JOSE, CA, USA, Seiten 17 - 24

## Beschreibung

Die Erfindung bezieht sich auf ein lithographisches Verfahren zur Herstellung von Mikrostrukturen gemäß den im Oberbegriff des Patentanspruchs 1 angegebenen Merkmalen.

Aus "APPLIED OPTICS, 1 NOV. 1987, USA, Bd. 26, Nr. 21, ISSN 0003-6935, Seiten 4587-4592, HARUNA M ET AL, Laser-beam writing System for optical integrated circuits" ist ein lithographisches Verfahren zum direkten Schreiben mittels eines fokussierten kohärenten Laserstrahls bekannt, wobei ein Modulator zur Modulation der Intensität des Laserstrahls vorgesehen ist. Nach welchen Kriterien die Modulation erfolgt ist nicht erläutert. Gemäß dem vorbekannten Verfahren können Strukturen in der Größenordnung von 3 bis 4 µm erzeugt werden, doch besteht heute das Erfordernis zur Herstellung von noch kleineren Strukturen.

Femerwerden in "OPTICAL ENGINEERING, JAN. 1986, USA, Bd. 25, Nr. 1, ISSN 0091-3286, Seiten 180-183, KUTTNER P, Image quality of optical systems for truncated Gaussian laser beams" die Abhängigkeiten einer Modulationübertragungsfunktion von verschiedenen Eigenschaften eines optischen Abbildungssystems erläutert. Für einen Laserstrahl, welcher bekanntlich eine Gauss'sche Intensitätsverteilung besitzt, werden die Zusammenhänge unter Einsatz einer Lochblende dargelegt, wobei zur optischen Datenspeicherung ein möglichst scharf gebündelter Strahl vorausgesetzt wird. Zur Intensitätsmodulation des Laserstrahls in Abhängigkeit der Raumfrequenz lassen sich keine Angaben entnehmen.

In "IBM TECHNICAL DISCLOSURE BULLETIN, Bd. 23, Nr. 7A, Dezember 1980 NEW YORK, US, Seiten 2723-2724, ANONYMOUS, Frequency Dependent Mask Windage for Improved Mask Modulation. December 1980" ist die frequenzabhängige Ablenkung eines Strahls erläutert, um eine verbesserte Maskenmodulation zu erhalten. Hierbei wird zur Herstellung der Modulationsübertragungsfunktion eine Verkleinerung der Maskenöffnungen vorgeschlagen. In der Praxis läßt sich jedoch die Maskenöffnung nicht ohne weiteres noch weiter verkleinern, und es sind keine Hinweise zu entnehmen, zur Herstellung kleiner Strukturen die Intensität des Laserstrahls zu verändern.

Des weiteren ist aus "Solid State Technology, December 1985, pages 81-85" ein nicht-lithographisches Verfahren bekannt, demgemäß ohne Masken durch direktes Schreiben mit Laserstrahlen Bereich belichtet oder nicht belichtet werden, um vorgegebene Strukturen zu erhalten. Mittels des fokussierten Laserstrahls werden ähnlich einer Punktmatrix vorgebbare Bereiche entsprechend der zu erzeugenden Struktur belichtet, um insbesondere Mikrostrukturen auf Substraten für die Mikroelektronik zu erzeugen. Die Ausbildung der Mikrostrukturen wird maßgeblich von der Lichtenergie des Lasers sowie der Empfindlichkeit des zum Einsatz gelangenden Fotolacks abhängen. Aufgrund des nicht unerheblichen Fertigungs- und Geräteaufwandes wird das direkte Schreiben, durch welches Strukturen unter 0,25 Mikrometer erzeugt werden können, heute üblicherweise zur Herstellung von Masken zur Erzeugung von Mikroelektronik-Schaltkreisen auf Halbleiterwafern genutzt. Ein System für das direkte Schreiben hat vollständig inkohärente Abbildungseigenschaften. Um möglichst steile Übergänge oder Wände des Fotolacks zu erhalten, kann ferner beim direkten Schreiben die Tiefe des Fokus recht groß sein.

Ferner ist aus der DE-A-31 18 802 ein Gerät zur Übertragung eines Maskenmusters auf ein Halbleiterplättchen bekannt. Hierbei werden mehrere Teilbelichtungen durchgeführt, wobei die Relativlage zwischen dem Maskenmuster und dem Halbleiterplättchen für jede Teilbelichtung um eine sehr kleine Strecke verändert wird. Somit kann auf dem Halbleiterplättchen ein Muster erzeugt werden, welches eine geringere Breite der Linien aufweist als das Maskenmuster. Mit derartigen lithografischen Verfahren können unter Einsatz von Masken zur Erzeugung von Schaltungen für die Mikroelektronik Mikrostrukturen bis zu 0,25 Mikrometer erzeugt werden. Erforderlich sind hierbei optische Systeme mit hoher numerischer Apertur und eine Lichtquelle mit kurzer Wellenlänge. Mit derartigen auch als Stepper bezeichneten Systemen können Bereiche bis zu 30 x 30 mm² bearbeitet werden, wobei der komplette Wafer stufenweise mit identischen Abbildungen gemäß der Maske belichtet wird. Für ein derartiges kohärentes System ist die maximale räumlich abzubildende Frequenz nur die Hälfte derer eines inkohärenten Systems. Dies gilt, obgleich in einem kohärenten System die Modulationstiefe kontinuierlich abfällt. Daher liegt regelmäßig in den heute zum Einsatz gelangenden Stepper-Systemen der Grad der Kohärenz in der Größenordnung von 0,5.

Desweiteren ist aus der DE-A-34 01 963 ein Verfahren zur Herstellung von Photoresist-Strukturen mit gestuften Flanken bzw. abgesetzten Fensteröffnungen unter Einsatz von Masken bekannt. Es werden zwei Varianten aufgezeigt, bei welchen jeweils von einem Glasträger mit einseitiger Metallisierung ausgegangen wird. Die Herstellung der Masken und vor allem die exakte Ausrichtung derselben bezüglich des Glasträgers, welcher einseitig die Metallisierung aufweist, erfordert einen recht hohen Fertigungsaufwand.

Schließlich ist in dem Buch: "Informationstherorie in der Optik", Dr. Rainer Röhler, Wissenschaftliche Verlagsgesellschaft mbH Stuttgart, 1967, auf den Seiten 16 bis 21 sowie 82 bis 92 die Abbildung und Interpretation von bestehenden Objekten erläutert. Es wird die für die Abbildungseigenschaften maßgebliche Modulationsübertragungsfunktion (MÜF) in Zusammenhang mit der Abbildung von inkohärent beleuchteten Objekten beschrieben. Bei einer kohärenten Abbildung führt jedoch eine Beeinflussung der Modulationsübertragungsfunktion nicht zu einer Verbesserung der Abbildungseigenschaften.

Hiervon ausgehend liegt der Erfindung die Aufgabe zugrunde, das Verfahren zum direkten Schreiben dahingehend auszubilden, daß die Strukturen kleiner als die optische Auflösung erzeugt werden können.

Die Lösung dieser Aufgabe erfolgt gemäß den kennzeichnenden Merkmalen des Patentanspruchs 1.

Das erfindungsgemäße Verfahren ermöglicht unter Einsatz eines Systems für das direkte Schreiben eine erheblich verbesserte und bis um den Faktor 2 vergrößerte Auflösung zu erhalten. Es gelangt ein System zum direkten Schreiben zum Einsatz, welches grundsätzlich inkohärente Abbildungseigenschaften aufweist und welches im Vergleich mit einem kohärenten Abbildungssystem, beispielsweise unter dem Einsatz von Masken, die doppelte Auflösung besitzt. Obgleich als Beleuchtungsquelle ein kohärenter Laser zum Einsatz gelangt, ist die Äbbildungseigenschaft des Gesamtsystems inkohärent und die dynamische Modifikation der Modulationsübertragungsfunktion führt erfindungsgemäß zu einer Abbildungsverbesserung. Mittels des Lithographiesystems wird die Struktur seriell durch Abrastern der photosensitiven Schicht erzeugt, wobei im Vorfeld der Datenaufbereitung eine Modulation der Intensität des Lasers in Abhängigkeit der Raumfrequenz der jeweiligen Struktur durchgeführt wird. Es gelangt ein direkt schreibendes Lasergerät mit einem herkömmlichen optischen Abbildungssystem zum Einsatz und gleichwohl werden Mikrostrukturen erzeugt, welche wesentlich kleiner sind als die mit diesem System gerade noch zu erreichende Basisauflösung. Erfindungsgemäß wird ein lithografisches Verfahren vorgeschlagen, welches die Herstellung von Strukturen kleiner als 2,5 Mikrometer unter Einsatz üblicher optischer Technologien und Geräten zuläßt. Dies wird erfindungsgemäß dadurch ermöglicht, daß die zu schreibende Abbildung derart vorgenommen wird, daß die Intensität der räumlichen Frequenzen für die höheren Frequenzen angehoben wird. Hierdurch wird ein nahezu flaches Ergebnis in der Auflösung in dem derart kombinierten System erreicht. Darüber hinaus wird die Energie in zweckmäßiger Weise derart eingestellt, daß der fotoempfindliche Lack bei einem Pegel in der Größenordnung zwischen 40 bis 60 %, insbesondere von 50 %, schaltet, so daß sehr steile Kanten des Lackes auch mit dem System für das direkte Schreiben erreicht werden. Mit dem Begriff "Schalten" ist die Eigenschaft des photoempfindlichen Lacks angesprochen, erst ab einer bestimmten Lichtenergie belichtet zu werden, wobei erst nach entsprechender Belichtung die Polymere des lichtempfindlichen Lacks derart modifiziert werden, daß eine selektive Wechselwirkung mit der Chemie der weiterverarbeitenden Prozesse ermöglicht wird.

In einer besonderen Ausgestaltung der Erfindung wird die Technik der mehrfachen Entwicklung genutzt, um so mit einer hohen Frequenz die Lackstruktur zu erzeugen. So ist es insbesondere möglich, eine Struktur mit Linien von 0,25 Mikrometer Breite und ebenso großen Zwischenräumen zu erzeugen, obgleich die kleinste zu entwickelnde Struktur 0,75 Mikrometer groß ist. Darüber hinaus kann ein vergleichbares Verfahren in zwei Dimensionen vorgeschlagen werden, um so sehr kleine positive Strukturen zu erzeugen. Schließlich kann mittels eines negativen oder positiven Lacks jeder Kontrast hergestellt werden. In einer besonderen alternativen Ausgestaltung der Erfindung können sehr hohe Stukturen mit dem Mehrfach-Belichtungsverfahren erzeugt werden. Hierbei wird exakt über eine erste Lage, welche zuvor bereits belichtet und hergestellt worden ist, ein zweite Lage belichtet.

Die Erfindung wird nachfolgend anhand der Zeichnung näher erläutert. Es zeigen:
- Fig. 1: die Intensität des Lichtes in einer Schicht eines Fotolacks als Funktion der Fokustiefe eines Systems für das direkte Schreiben,
- Fig. 2: eine schematische Darstellung von sechs übereinander dargestellten Verfahrensschritten.

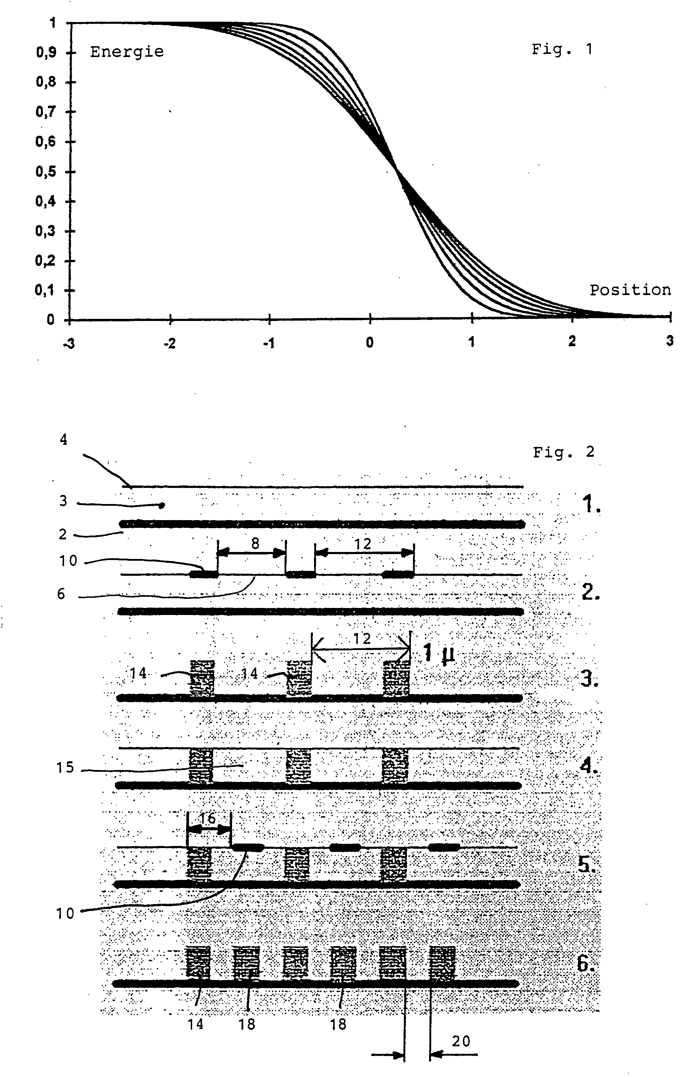

Fig. 1 zeigt für ein System zum direkten Schreiben in einer normierten Darstellung die Intensität des Lichtes in einer Schicht des Fotolacks als eine Funktion der Fokustiefe, und zwar zwischen 0 und 2,5 Mikrometer bezogen auf eine Ecke oder Kante. Für de Fall, daß der Fotolack die Eigenschaft hat, exakt bei einer Energie bzw Intensität von 0,5 zu reagieren, kann die Fokustiefe des Systems zum direkten Schreiben sehr goß sein. Hieraus ist ferner ersichtlich, daß nach dem Entwickeln sehr steile Wände bzw. Strukturkanten erzeugt werden.

Es erfolgt im Vorfeld der Datenaufbereitung eine Modulation der Intensität des Lasers in Abhängigkeit der Raumfrequenz der jeweiligen Struktur. Hierbei gelangt ein Lithographiesystem zum Einsatz, welches durch Abrastern der photosensitiven Schicht das Objekt seriell erzeugt. Obgleich als Beleuchtungsquelle ein kohärenter Laser zum Einsatz gelangt, wird erfindungsgemäß eine dynamische Modifikation der Modulationsübertragungsfunktion durchgeführt, so daß insgesamt inkohärente Abbildungseigenschaften für das Gesamtsystem erreicht werden.

Gemäß Fig. 2 wird in einem ersten Verfahrensschritt das Substrat 2 mit Fotolack 3 beschichtet, dessen Oberkante als durchgehende Linie 4 dargestellt ist.

Nachfolgend werden Linien 6 in einer kleinsten möglichen Breite 8, insbesondere von 0,75 Mikrometer belichtet. Im Rahmen der Erfindung gelangt ein optisches System mit vorgegebener optischer Auflösung zum Einsatz, gemäß welchem die kleinsten zu entwickelnden Strukturen die anggegebene kleinste Breite 8 aurweisen. Die nicht belichteten Teile sind aus Gründen der Übersicht stark hervorgehoben. Die gemäß Zeichnung jeweils linken Kanten der belichteten Teile 10 weisen einen Abstand 12 von 1 Mikrometer auf. Dieser Abstand 12 wird als Pitch bezeichnet.

Im dritten Verfahrensschritt erfolgt die Entwicklung und die erfindungsgemäße Herstellung eines ersten Satzes von Strukturen 14.

Nun folgt erfindungsgemäß eine zweite "Belichtungsstufe". Im vierten Verfahrensschritt wird nochmals Fotolack aufgebracht, welcher nunmehr die Zwischenräume zwischen den bisher erzeugten Strukturen 14 ausfüllt.

In dem erfindungswesentlichen fünften Verfahrensschritt folgt wiederum eine Belichtung, ähnlich Verfahrensschritt 2, mit der kleinstmöglichen Schreibbreite 8 des Systems, jedoch mit einem vorgegebenen Versatz 16, welcher in diesem Ausführungsbeispiel 0,5 Mikrometer groß ist.

Im sechsten Verfahrensschritt wird der Fotolack entwickelt und ein zweiter Satz 18 von Strukturen in bekannter Weise hergestellt. Aufgrund des erfindungsgemäß vorgegebenen seitlichen Versatzes 16 während der zweiten Belichtungsstufe gemäß den Verfahrensschritten 4 bis 6 liegen die Strukturen des zweiten Satzes 18 zwischen den Strukturen 14 der ersten Belichtungsstufe. Da der Versatz 16 für die zweite Belichtungsstufe genau die Hälfte vom Pitch 12 beträgt, liegen die Strukturen 18 des zweiten Satzes exakt zwischen den Strukturen des ersten Satzes.

Gemäß dem erfindungsgemäßen Verfahren können somit unter Einsatz eines direkten Schreibsystems, mit welchem die schmalsten Linien insbesondere 0,75 Mikrometer groß sind, durch Vorgabe des Versatzes in einer zweiten Belichtungsstufe Strukturen und/oder Zwischenräume von 0,25 Mikrometer hergestellt werden.

Gemäß obigen Ausführungen erfolgte der Versatz in der zweiten Belichtungsstufe in der einen Richtung. Je nach Ausbildung der zu erzeugenden Strukturen kann zusätzlich oder alternativ auch die Verschiebung in einer anderen Richtung, beispielsweise senkrecht zur Zeichenebene, erfolgen, auch in der anderen Richtung 0,25 Mikrometer breite Linien und Zwischenräume zu erzeugen.

Gemäß einer alternativen Ausgestaltung der Erfindung wird die zweite Belichtungsstufe ohne Versatz durchgeführt. Die zweite Lage gemäß den oben erläuterten Schritten 4 bis 6 wird genau über die der ersten Belichtungsstufe belichtet. Es wird also ein Mehrfach-Belichtungsverfahren vorgeschlagen, welches die Herstellung von sehr hohen Strukturen ermöglicht.

### Bezugszeichen

- 2: Substrat
- 3: Fotolack
- 4: Oberkante
- 6: Linie
- 8: Breite
- 10: nicht belichteter Teil
- 12: Pitch
- 14: erster Satz von Strukturen
- 15: Zwischenraum
- 16: Versatz in der zweiten Belichtungsstufe
- 18: zweiter Satz von Strukturen
- 20: Breite des Spaltes zwischen den Strukturen 14 und 18

## Patentansprüche

1. Lithographisches Verfahren zur Herstellung von Mikrostrukturen mit einem System zum direkten Schreiben, wobei mittels eines fokussierten kohärenten Laserstrahls zur seriellen Erzeugung einer Struktur vorgegebene Bereiche einer fotosensitiven Schicht durch Abrastern belichtet werden und wobei eine Modulation der Intensität des Laserstrahls durchgeführt wird,
**dadurch gekennzeichnet, dass** unter Einsatz eines inkohärenten Abbildungssystems die Modulation der Intensität des Laserstrahls in Abhängigkeit der Raumfrequenz der jeweiligen Struktur durchgeführt wird,
dass die Intensität des Laserstrahls mit zunehmender Raumfrequenz erhöht wird und daß die Energie des Laserstrahls derart vorgegeben wird, dass die fotosensitive Schicht beim Einwirken von 40 % bis 60 % der Laserstrahlenergie belichtet wird.

2. Lithographisches Verfahren nach Anspruch 1, **dadurch gekennzeichnet, dass** die fotosensitive Schicht beim Einwirken von im wesentlichen 50 % der Laserstrahlenergie belichtet wird.

3. Verfahren nach Anspruch 1 oder 2, **dadurch gekennzeichnet, dass** nach einer ersten Belichtungsstufe mit nachfolgendem Entwickeln und Ausbilden eines ersten Satzes von Strukturen (14) eine zweite Belichtungsstufe durchgeführt wird, wobei die Belichtung jedoch mit einem vorgebbaren Versatz (16) durchgeführt wird und versetzte zweite Strukturen (18) erzeugt werden.

4. Verfahren nach Anspruch 3, **dadurch gekennzeichnet, dass** der Versatz (16) für die zweite Belichtungsstufe derart vorgegeben wird, dass nach dem letzten Entwikkeln auch in den Zwischenräumen (15), welche während der ersten Belichtungsstufe zwischen den benachbarten Strukturen (14) entstanden, die weiteren Strukturen (18) liegen.

5. Verfahren nach Anspruch 1 oder 2, **dadurch gekennzeichnet, dass** nach einer ersten Belichtungsstufe mit nachfolgendem Entwickeln und Ausbilden eines ersten Satzes von Strukturen (14) eine zweite Belichtungsstufe durchgeführt wird, wobei die Belichtung ohne einen Versatz durchgeführt wird und zweite Strukturen (18) genau über den ersten Strukturen (14) erzeugt werden.

## Claims

1. Lithographic method for the production of microstructures with a direct-writing system, in which predetermined regions of a photosensitive layer are exposed by scanning by means of a focused coherent laser beam for the serial production of a structure and in which the intensity of the laser beam is modulated, **characterised in that** the intensity of the laser beam is modulated as a function of the spatial frequency of the respective structure using an incoherent imaging system, that the intensity of the laser beam is increased with increasing spatial frequency and that the energy of the laser beam is predetermined in such a manner that the photosensitive layer is exposed by the action of 40 % to 60 % of the laser-beam energy.

2. Lithographic method according to claim 1, **characterised in that** the photosensitive layer is exposed by the action of substantially 50 % of the laser-beam energy.

3. Method according to claim 1 or claim 2, **characterised in that** a first exposure stage with subsequent development and the formation of a first set of structures (14) is followed by a second exposure stage in which the exposure is carried out with a predetermined offset (16) and offset second structures (18) are produced.

4. Method according to claim 3, **characterised in that** the offset (16) for the second exposure stage is predetermined in such a manner that the further structures (18) are also situated in the spaces (15) produced between the adjacent structures (14) during the first exposure stage after the final development.

5. Method according to claim 1 or claim 2, **characterised in that** a first exposure stage with subsequent development and the forrnation of a first set of structures (14) is followed by a second exposure stage in which the exposure is carried out without an offset and second structures (18) are produced precisely over the first structures (14).

## Revendications

1. Procédé lithographique pour fabriquer des microstructures avec un système d'écriture directe, des zones prédéterminées d'une couche photosensible étant exposées au moyen d'un rayon laser cohérent focalisé afin de produire en série une structure, et une modulation de l'intensité du rayon laser étant effectuée, ***caractérisé***
***en ce qu***'en utilisant un système de reproduction non cohérent, la modulation de l'intensité du rayon laser est effectuée en fonction de la fréquence spatiale de la structure concernée,
***en ce que*** l'intensité du rayon laser est augmentée pour une fréquence spatiale croissante et
***en ce que*** l'énergie du rayon laser est imposée de telle manière que la laque photosensible est exposée sous l'action de 40 % à 60 % de l'énergie du rayon laser.

2. Procédé lithographique selon la Revendication 1, ***caractérisé en ce que*** la couche photosensible est exposée sous l'action de, pour l'essentiel, 50 % de l'énergie du rayon laser.

3. Procédé selon la Revendication 1 ou 2, ***caractérisé en ce qu***'après une première étape d'exposition avec développement et formation ultérieurs d'un premier jeu de structures (14), une deuxième étape d'exposition a lieu, l'exposition étant effectuée cependant avec un décalage (16) prédéterminable et des deuxièmes structures (18) décalées étant produites.

4. Procédé selon la Revendication 3, ***caractérisé en ce que*** le décalage (16) pour la deuxième étape d'exposition est imposé de telle manière qu'après le dernier développement, les autres structures (18) se trouvent également dans les interstices (15) formés entre des structures voisines (14) lors de la première étape d'exposition.

5. Procédé selon la Revendication 1 ou 2, ***caractérisé en ce qu***'après une première étape d'exposition avec développement et formation ultérieurs d'un premier jeu de structures (14), une deuxième étape d'exposition a lieu, l'exposition étant effectuée sans décalage et des deuxièmes structures (18) étant produites exactement au-dessus des premières structures (14).
